# EUROPEAN PATENT APPLICATION

(11) **EP 3 324 717 A1**
(43) Date of publication of application: **23.05.2018**
(21) Application number: 17179075.1
(22) Date of filing: 30.06.2017
(51) Int. Cl.: H05K 9/00

(54) **COMMUNICATION DEVICE**

(30) Priority: 22.11.2016 CN 201621247823 U
(71) Applicant: Sercomm Corporation, Taipei 115 (TW)
(72) Inventor: Chien, Yuan-Fu, 115 Taipei City (TW)
(74) Representative: dompatent von Kreisler Selting Werner - Partnerschaft von Patent- und Rechtsanwälten mbB

(57) **Abstract**

A communication device is provided. The communication device includes a circuit board, a connector and a RF noise shield. The connector is disposed on the circuit board for being connected with an external connector on a docking side of the connector. The RF noise shield is disposed on the circuit board and configured to cover and be separated from the connector by a spacing. The RF noise shield further has an opening arranged on the docking side. The opening is arranged on a side of the RF noise shield facing the external device, such that the RF noise shield forms an absorptive/reflective cavity. When the external device approaches or connects, not only the RF noise radiated from the connector of the external device but also the RF noise radiated from the connector of the device itself may be absorbed and/or reflected through the absorptive/reflective cavity.

## Description

### BACKGROUND OF THE INVENTION

### Field of the Invention

The disclosure relates to a communication device, and more particularly to a communication device capable of avoiding the radio frequency noise produced by itself and the connector of the external device.

### Description of the Related Art

With the development of technology, various communication products continuously advance all the time, and the transmission rate of signals also becomes faster and faster. However, due to high-speed transmission, the connector may easily radiate radio frequency (RF) noise which affects the operation of the electronic device itself. Furthermore, even though the RF noise produced by the connector of the device itself is suppressed, the RF noise radiated from the connector of the external docking device still cannot be avoided. Thus, the operation of the device itself may be affected.

### SUMMARY OF THE INVENTION

The disclosure is directed to a communication device. The RF noise shield covers and is separated from the connector by a spacing. The RF noise shield is provided with an opening arranged on a side of the RF noise shield facing the external docking device, such that the RF noise shield forms an absorptive/reflective cavity. When the external device approaches or connects, not only the RF noise radiated from the connector of the external device but also the RF noise radiated from the connector of the device itself may be absorbed and/or reflected through the absorptive/reflective cavity, thereby preventing such RF noise from affecting the operation of the device itself.

According to the present disclosure, a communication device is provided. The communication device includes a circuit board, a connector and a RF noise shield. The connector is disposed on the circuit board for being connected with an external connector on a docking side of the connector. The RF noise shield is disposed on the circuit board and configured to cover and be separated from the connector by a spacing. The RF noise shield further has an opening arranged on the docking side.

The above and other aspects of the invention will become better understood with regard to the following detailed description of the preferred but non-limiting embodiment(s). The following description is made with reference to the accompanying drawings.

### BRIEF DESCRIPTION OF THE DRAWINGS

FIG. 1 is a schematic diagram illustrating the appearance of a communication device according to one embodiment of the present disclosure.
FIG. 2 is a schematic diagram of a communication module of the communication device of FIG. 1.
FIG. 3 is a cross-sectional view of the communication device of FIG. 1 along direction3-3'.
FIG. 4 is a side view of the communication module of FIG. 2.

### DETAILED DESCRIPTION OF THE INVENTION

The following content is made with reference to the accompanying drawings and specific embodiments to describe the present disclosure in detail for a further understanding of the purposes, techniques and effects of the present disclosure. However, the scope of the appended claims of the present disclosure is not limited thereto.

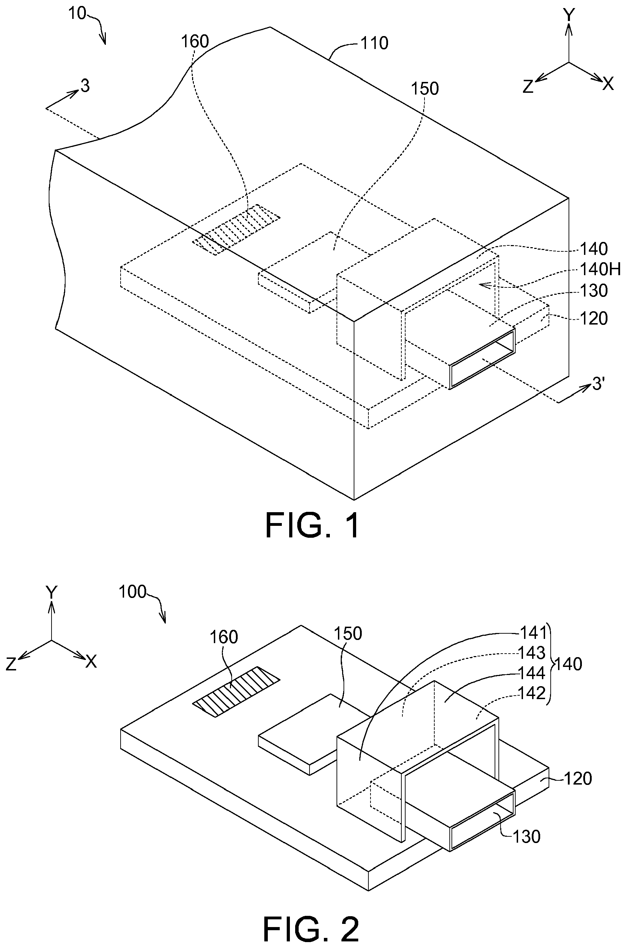

FIG. 1 is a schematic diagram illustrating the appearance of a communication device 10 according to one embodiment of the present disclosure. FIG. 2 is a schematic diagram of a communication module 100 of the communication device 10 of FIG. 1.

Referring to FIG. 1 and FIG. 2, the communication device 10 includes a housing 110 and a communication module 100. The housing 110 houses the communication module 100. The communication module 100 includes a circuit board 120, a connector 130 and a RF noise shield 140.

As shown in FIG. 1, the connector 130 is disposed on the circuit board 120. Specifically, the connector 130 is disposed on a side portion of the circuit board 120 for the connector of an external connection device (not illustrated) to plug in. For example, the connection port of the connector 130 may be arranged towards a docking side (the positive x-axis direction as shown in FIG. 1) for being connected with the connector of the external connection device on the docking side. The connector 130 may be, for example, a universal serial bus (USB) 3.0 or higher connector, or may be a high definition multimedia interface (HDMI) connector, but the present disclosure is not limited thereto. In the case of the wireless communication device 10 using the connector 130 conformed to USB 3.0 specification, the radio frequency noise produced by the connector 130 and the connector of the external connection device may interfere with the wireless signal ranging between 2GHz and 5GHz during the operation of the wireless communication device 10.However, through the arrangement of the RF noise shield 140, it is possible to effectively improve signal quality which may otherwise be affected by the electromagnetic interference (EMI).

As shown in FIG. 1, the RF noise shield 140 is disposed on the circuit board 120. The RF noise shield 140 covers the connector 130. In addition, the RF noise shield 140 is separated from the connector 130 by a spacing. That is, the RF noise shield 140 is not in contact with the connector 130 directly. Furthermore, the RF noise shield 140 further has an opening 140H arranged on the docking side (the positive x-axis direction as shown in FIG. 1).

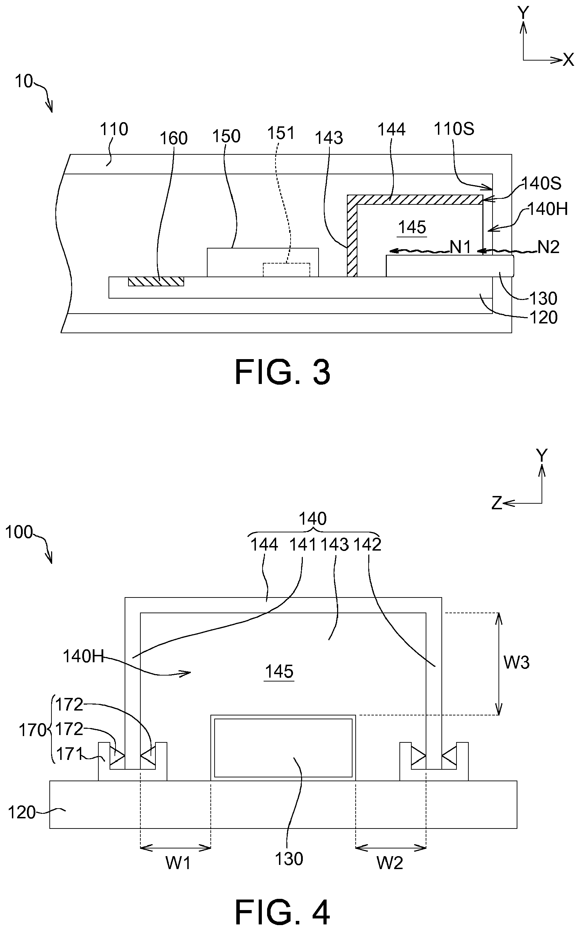

Referring to FIG. 3, a cross-sectional view of the communication device 10 of FIG. 1 along direction 3-3' is shown. The communication device 10 may further include an antenna module 160, a communication chip 151 and a shield 150. The antenna module 160 is disposed on the circuit board 120. The communication chip 151 is disposed on the circuit board 120, and is electrically connected with the antenna module 160 through traces (not illustrated) to receive a signal from the antenna module 160 or transmit a signal to the antenna module 160.The shield 150 is disposed on the circuit board 120 and covers the communication chip 151. Since the shield 150 is grounded, the communication chip 151 may be less affected by or be more immune from EMI directly under the protection of the shield 150.On the other hand, because the RF noise shield 140 prevents some RF noise from entering the antenna module 160, the RF noise shield 140 indirectly makes the communication chip 151 less affected by or more immune from EMI.

Referring to FIG. 2 and FIG. 3, since the RF noise shield 140 is provided with the opening 140H only on the docking side, an absorptive/reflective cavity 145 is formed among the RF noise shield 140, the circuit board 120 and the connector 130. In particular, the RF noise shield 140 is made of metal. Thus, the absorptive/reflective cavity 145 surrounded by the RF noise shield 140 may be capable of absorbing and/or reflecting RF noise. That is, after the electromagnetic wave enters the absorptive/reflective cavity 145, the energy of the electromagnetic wave will decay greatly due to many times of reflection/absorption. Therefore, not only the RF noiseN1 produced by the connector 130 of the communication device 10 itself, but also the RF noise N2 produced by the connector of the external connection device (not illustrated) on the docking side may decay greatly since being absorbed and/or reflected many times within the absorptive/reflective cavity 145. Moreover, since the absorptive/reflective cavity 145 of the RF noise shield 140 has the opening 140H, and the opening 140Hof the RF noise shield 140 is configured to face away from the antenna module 160, some of the RF noise N1 and N2 maybe reflected away towards the docking side (i.e., the positive x-axis direction) through the opening 140H even though the RF noise N1 and N2 does not completely decay after many times of reflection/absorption. As a result, much less of the RF noise N1 and N2 will interfere with the antenna module 160 on the other side to further affect the communication chip 151.

Since the aforementioned absorptive/reflective cavity 145 may reduce interference caused by the RF noise N1 and N2 to the antenna module 160, the larger the coverage of space the absorptive/reflective cavity 145 and/or the opening 140Hare/is, the better the shielding effect is. In one embodiment, the spacing between the RF noise shield 140 and the connector 130 has a distance of at least 1 mm, so that the noise from the connector 130 and the connector of the docking device may be shielded effectively.

The RF noise shield 140 may include a plurality of side walls. For example, referring to FIG. 2 and FIG. 3, the RF noise shield 140 may further include a top wall 144, and a first side wall 141, a second side wall 142 and a third side wall 143 respectively connected to the top wall 144. The first side wall 141 is opposite to the second side wall 142, and the third side wall 143 is opposite to the docking side.

FIG. 4 is a side view of the communication module 100 of FIG. 2. Referring to FIG. 2 and FIG. 4, with a view from the positive x-axis towards y-z plane, the RF noise shield 140 may be in the form of an upside-down U shape. In the present embodiment, the first side wall 141 and the connector 130 has a distance of W1, the second side wall 142 and the connector 130 has a distance of W2, and the top wall 144 and the connector 130 has a distance of W3, whereinW1, W2 and W3 may be equal or unequal. However, if W1, W2 and W3 are larger, the shield effect is better. In one embodiment, W1 and W2 may be at least 1 mm, and W3 may be at least 3 mm.

As shown in FIG. 1 and FIG. 3, the housing 110 houses the circuit board 120, the connector 130 and the RF noise shield 140, and exposes the connection port of the connector 130 on the docking side. In addition, the housing 10 further hides the opening 140H to prevent the RF noise shield 140 form being exposed unattractively. In one embodiment, the edge 140S of the RF noise shield 140 may extend towards the positive x-axis direction and be in contact with the inner surface 110S of the housing 110to enlarge the space of the absorptive/reflective cavity 145 as much as possible. Moreover, in one embodiment, the connector 130 is a female connector. In such a condition, the connector of the external connection device may be a male connector. Through the RF noise shield 140, it is possible to not only avoid the noise produced by the connector 130 itself effectively, but also suppress the noise produced by any male connector to a certain extent.

The communication module 100 may further include a plurality of clipping elements 170 for clamping a plurality of side walls of the RF noise shield 140 on the circuit board 120. For example, referring to FIG. 4, the communication module 100 may be provided with three or more than three clipping elements 170 respectively for securing the first side wall 141, the second side wall 142 and the third side wall 143 of the RF noise shield 140 on the circuit board 120. Each clipping element 170 is disposed on the circuit board 120. For example, each clipping element 170 may be disposed on the circuit board 120 through welding. Each clipping element 170 may include a base 171 and two elastic clipping portions 172 respectively disposed on both sides of the recess of the base 171. As shown in FIG. 4, the two elastic clipping portions 172 of the clipping element 170 for clamping the first side wall 141 or the second side wall 142 are elastic along the z-axis direction, while the two elastic clipping portions 172 of the clipping element 170 for clamping the third side wall 143 (blocked by the connector 130 and not shown in the drawing) are elastic along the x-axis direction. The first side wall 141, the second side wall 142 or the third side wall 143 may be clamped between the two elastic clipping portions 172, so that the RF noise shield 140 is secured on the circuit board 120.Under such a design, the clipping element 170 may be adapted to secure the RF noise shield140 with different wall thicknesses. On the other hand, through the clipping element 170, user may disassemble the RF noise shield 140 freely without damaging the circuit board 120 when a detection or maintenance is required. The RF noise shield 140 may be grounded, e.g. through the clipping elements 170.

In the aforementioned embodiments, the absorptive/reflective cavity 145 is formed among the RF noise shield 140, the circuit board 120 and the connector 130, and the RF noise shield 140 is further provided with an opening 140H on the docking side. Since the RF noise shield 140 is separated from the connector 130 by a spacing, not only the RF noise N1 radiated from the connector 130 of the device itself, but also the RF noise N2 radiated from the connector of the external connection device may be absorbed and/or reflected through the absorptive/reflective cavity 145, so that the operation of the device itself will be less affected by or be more immune from the RF noiseN1 and N2. Furthermore, since the opening 140H is configured to face away from the antenna module 160, some of the RF noise may leave through the opening 140H after absorbed and/or reflected by the absorptive/reflective cavity 145. As a result, the RF noise N1 and N2has less chance to interfere with the antenna module 160 on the other side.

While the invention has been described by way of example and in terms of the preferred embodiment(s), it is to be understood that the invention is not limited thereto. On the contrary, it is intended to cover various modifications and similar arrangements and procedures, and the scope of the appended claims therefore should be accorded the broadest interpretation so as to encompass all such modifications and similar arrangements and procedures.

## Claims

1. A communication device (10), **characterized in that** the communication device comprises:
a circuit board (120);
a connector (130) disposed on the circuit board for being connected with an external connector on a docking side of the connector; and
a RF noise shield (140) disposed on the circuit board and configured to cover and be separated from the connector by a spacing, the RF noise shield having an opening (140H) arranged on the docking side.

2. The communication device according to claim 1, **characterized in that** the communication device further comprises:
an antenna module (160) disposed on the circuit board;
wherein the opening of the RF noise shield is configured to face away from the antenna module.

3. The communication device according to claim 2, **characterized in that** the communication device further comprises:
a communication chip (151) disposed on the circuit board and electrically connected with the antenna module; and
a shield (150) disposed on the circuit board and covering the communication chip.

4. The communication device according to claim 1, **characterized in that** the spacing between the RF noise shield and the connector has a distance of at least 1 mm.

5. The communication device according to claim 1, **characterized in that** the RF noise shield further comprises a top wall (144), and a first side wall (141), a second side wall (142) and a third side wall (143) connected to the top wall, wherein the first side wall is opposite to the second side wall, and the third side wall is opposite to the docking side.

6. The communication device according to claim 5, **characterized in that** the spacing between the first side wall and the connector and the spacing between the second side wall and the connector respectively have a distance of at least 1 mm (W1, W2), and the spacing between the top wall and the connector has a distance of at least 3 mm (W3).

7. The communication device according to claim 1, **characterized in that** the communication device further comprises:
a plurality of clipping elements (170) disposed on the circuit board, each of the clipping elements having two elastic clipping portions (172) and welded on the circuit board;
wherein the RF noise shield further comprises a plurality of side walls (141, 142, 143), and each of the side walls is clamped between the two elastic clipping portions.

8. The communication device according to claim 1, **characterized in that** the RF noise shield is grounded.

9. The communication device according to claim 1, **characterized in that** the communication device further comprises a housing (110) housing the circuit board, the connector and the RF noise shield, wherein the housing exposes the connector on the docking side and hides the opening.

10. The communication device according to claim 1, **characterized in that** the connector is a USB 3.0 or higher connector, or a HDMI connector.
